# EUROPEAN PATENT APPLICATION

(11) **EP 1 744 450 A1**
(43) Date of publication of application: **17.01.2007**
(21) Application number: 05015322.0
(22) Date of filing: 14.07.2005
(51) Int. Cl.: H03G 3/32, H03G 3/34

(54) **Electronic device**

(71) Applicant: Harman Becker Automotive Systems GmbH, 76307 Karlsbad (DE)
(72) Inventor: Mauderer, Hans-Peter, 76571 Gaggenau (DE)
(74) Representative: Bertsch, Florian Oliver

(57) **Abstract**

Electronic device comprising
- a sound producing unit for producing sound,
- a sound reproduction unit for reproducing the produced sound,
- a sound detecting unit for detecting a predetermined sound characteristic,
- a control unit for controlling the electronic device in accordance with the detected sound characteristic.

## Description

This invention relates to an electronic device and to a method for controlling the sound of an electronic device. The invention relates especially to a built-in electronic device which is incorporated into a vehicle and which is used for reproducing the sound in the vehicle, be it the sound of a radio receiver, of a memory unit such as a compact disc or the sound of a telecommunication unit incorporated into the vehicle.

However, it should be understood that the invention can also be used in portable audio devices such as a portable audio player or a cell phone.

It often happens that a driver or a pedestrian using a portable audio player does not remark an approaching emergency vehicle. This is mainly due to the fact that the reproduced sound in the vehicle is reproduced at a volume that it masks the sound produced by an alarm horn of an emergency vehicle. This can lead to dangerous situations when the driver recognizes to late that an emergency vehicle driving at high speed is approaching.

Accordingly, a need exists to provide a possibility to alert a user of a sound producing device when an emergency vehicle is approaching.

This need is met by an electronic device and by a method as mentioned in the independent claims. In the dependent claims preferred embodiments of the invention are described.

According to a preferred embodiment of the invention, the electronic device comprises a sound producing unit for producing the sound for the user. Additionally, a sound reproduction unit is provided for reproducing the produced sound. In order to detect the ambient noise, a sound detecting unit is provided for detecting a predetermined sound characteristic. Additionally, a control unit is provided for controlling the electronic device in accordance with the detected sound characteristic. By detecting the ambient sound and by detecting a predetermined sound characteristic, an electronic device can be controlled in such a way that, in the case the predetermined sound characteristic, which may correspond to the sound characteristic of an alarm horn or a siren, is detected, the user is informed or alerted in any way.

Preferably, the control unit controls the sound reproduced by the sound reproduction unit in accordance with the detected sound characteristic. One way of informing the driver is by controlling the sound intensity or sound level of the reproduced sound. When a predetermined sound characteristic is detected, the sound control unit may lower the intensity of the reproduced sound, so that the user of the electronic device can detect or hear the alarm horn more easily.

According to a preferred embodiment of the invention, the device comprises a storage unit for storing different sound characteristics, the detected sound characteristic being compared to the stored sound characteristic by the control unit. The control unit itself controls the sound depending on the result of the comparison. The storage unit may comprise different sound characteristics of different emergency vehicles, such as a police car, a fire engine or an ambulance. The alarm horn of all these vehicles has a specific characteristic, and by storing the sound characteristics of the different alarm signals, an approaching emergency vehicle can be detected by comparing the detected ambient sound to the sound characteristics stored on the storage unit.

As described above, the control unit can react in such a way that it lowers the volume of the reproduced sound. However, it is also possible that the sound control unit outputs an audio warning when one of the predetermined sound characteristics is detected. This audio warning can be output without lowering the volume of the reproduced sound, or the audio warning can be output, and the volume is reduced at the same time.

According to another embodiment of the invention, it is possible, that the control unit outputs a visual warning when one of the predetermined sound characteristics is detected. When the electronic device is incorporated in a vehicle, a warning light may be activated which is incorporated into the dashboard of the vehicle, or the visual warning may be displayed on the windscreen of the vehicle. It should be understood that the different ways for informing the driver of an approaching emergency vehicle described above may be used together or alone. The audio and the visual warning can be combined or used alone, furthermore the volume of the reproduced sound can be lowered and/or the audio or visual warning can be output.

Preferably, the electronic device is a built-in device of a vehicle. The electronic device can also be a portable audio player or a mobile communication unit. The electronic device can be any mobile electronic device which can be used on the streets, where the possibility exists that an emergency vehicle is approaching. Often, electronic devices have earphones for the user of the device. When earphones are used, it is even more difficult for the user to recognize that an emergency vehicle is approaching, as the earphones damp the ambient noise. According to the invention, the sound, e.g. the music, will be lowered in volume, or an audio signal will be generated alerting the user of the portable electronic device.

According to a preferred embodiment of the invention, a microphone is used for the sound detecting unit for detecting the ambient sound. In nowadays multimedia systems incorporated into vehicles microphones are often provided, as these multimedia systems often comprise a telecommunication module, so that a microphone is necessarily provided within the electronic device. Additionally, many systems are also equipped with speech recognition systems which can be used for controlling the system. As a consequence, a microphone for recording the voice will be provided which can also be used for detecting the sound in the vehicle or the sound in the neighborhood of the electronic device if it is a portable device used outside a vehicle.

The invention also relates to a method for controlling the sound of an electronic device comprising the steps of reproducing a sound produced by a sound producing unit. Additionally, the ambient sound in the neighborhood of the reproduced sound is detected and after detection compared to at least one predetermined sound characteristic. Depending on the comparison, the sound of the reproduced sound is controlled. As described above, preferably the sound level of the reproduced sound is controlled, the sound level being lowered when the detected sound comprises a component which corresponds to a predetermined sound characteristic. Instead of lowering the sound level or in addition thereto a visual or an audio warning may be output when the detected sound comprises a signal component which corresponds to the predetermined sound characteristic of an alarm horn or a siren.

When the method of the invention is applied inside a vehicle, the sound inside a passenger compartment of the vehicle is detected and it is determined whether the detected sound comprises a predetermined sound characteristic. When a signal component has been detected which corresponds to the predetermined sound characteristic, it is determined whether the volume of the audio sound inside the vehicle is lower than the predetermined threshold value. If the audio sound inside the vehicle exceeds the threshold value, the volume of the reproduced sound inside the vehicle may be reduced. When the sound volume is lowered automatically, the driver recognizes that an emergency vehicle may be present next to the vehicle. Additionally, the driver can detect the alarm horn more easily when the volume of the reproduced sound is lowered.

For detecting whether the recorded sound comprises a signal component of an alarm horn, a detected signal of the time domain may be transformed to the frequency domain. In the frequency domain the different frequency components of the sound can be recognized. Each alarm horn has a specific sound, and therefore also has a specific frequency spectrum. By comparing the resulting frequency spectrum to predetermined frequency spectra, it can be detected whether one of the predetermined sound characteristics is comprised in the detected sound signal. When part of the resulting frequency spectrum corresponds to at least one predetermined frequency spectrum, the sound level of the reproduced sound may be controlled (i.e. lowered).

In general, hardware components and known electronic components can be used for detecting the predetermined sound characteristic. Additionally, the signal processing can be done with known software algorithms for recognizing predetermined sound characteristics in a sound spectrum.

Further advantages of the invention will become apparent from the following description with reference to the accompanying drawings.
Fig. 1 shows a schematic view of an electronic device according to the invention,
Fig. 2 shows a flowchart which comprises the steps for controlling the reproduced sound, and
Fig. 3 shows another flowchart in which the sound volume is lowered when an alarm horn is detected.

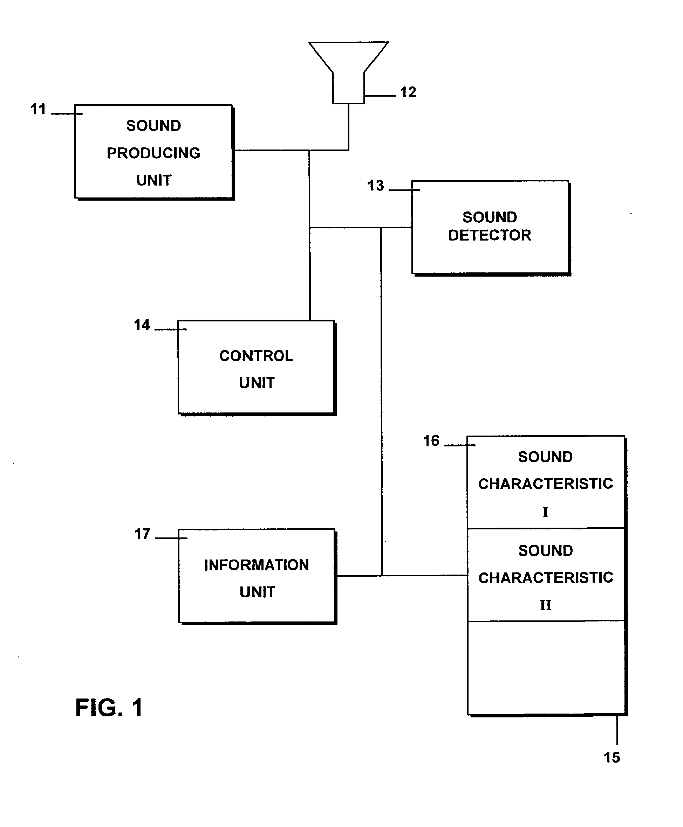

In Fig. 1 an electronic device is schematically shown which can be used for detecting a signal horn and for informing the user when a signal horn is detected. The device comprises a sound producing unit 11. The sound producing unit can be any audio source, by way of example a radio receiver, a compact disc player, a DVD player, or a telecommunication unit such as a cellular phone. Additionally, a loudspeaker 12 is provided as a sound reproduction unit. A loudspeaker can be part of a multimedia system provided in a vehicle, so that several loudspeakers 12 may be provided inside the vehicle. The loudspeaker may also be part of a set of earphones, the earphones being used either for a mobile audio player or for a mobile telecommunication unit. Additionally, a sound detector 13 is provided which detects the ambient sound around the electronic device. The sound detector may be a microphone incorporated into a cellular phone, the microphone of a multimedia system, or of any other portable audio player. The microphone will normally detect the sound emitted from the loudspeaker together with other sound components of the ambient sound. A control unit 14 controls the functioning of the electronic device, and may especially be used for determining how to inform the user of the fact that an emergency vehicle is approaching. For doing so, the control unit will compare the sound detected by the sound detector 13 to predetermined sound characteristics stored in a storage unit 15. In the storage unit different data sets 16 may be provided, each data set comprising a predetermined sound characteristic of an emergency vehicle. One sound characteristic may correspond to the sound characteristic of an alarm horn of a police car, the other sound characteristic may correspond to the sound characteristic of an ambulance, etc. Additionally, as the sounds of signal horns differ from country to country, the storage unit may also comprise signal horn characteristics of different countries. When the electronic device is part of a vehicle multimedia system comprising a navigation module, the navigation module may provide the information in which country the vehicle is moving at the moment. The control unit can then compare the detected sound to the stored sound characteristics of this country.

When the ambient sound comprises signal components which are in accordance with the signal characteristics stored in the storage unit 15, the control unit may react in different ways. First of all, the control unit may control the system in such a way that the sound volume emitted from the loudspeaker is lowered so that the user of the electronic device can hear the alarm horn more easily. Additionally, it is also possible that the sound producing unit produces on its own an alarm signal indicating to the user that an alarm horn was detected. Last but not least, it is also possible that the driver is informed by the information unit 17, where the information may be displayed, that a vehicle with an alarm horn is approaching.

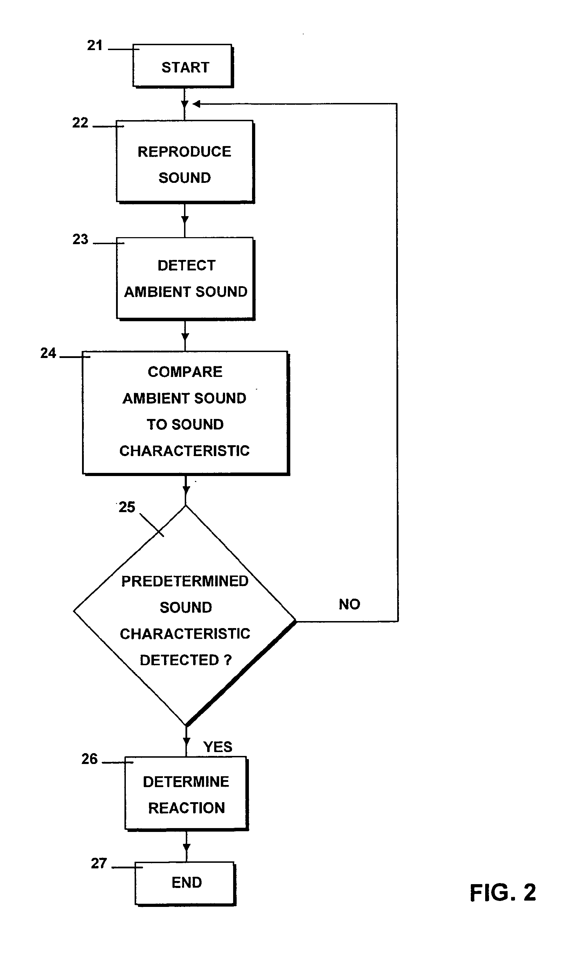

In Fig. 2 the steps carried out are shown in more detail after the start at step 21 the sound produced by the sound producing unit is reproduced in step 22. Additionally, the ambient sound is detected in step 23. The detected sound detected by the sound detector 13 is compared to the sound characteristics stored in the storage unit 15 (step 24). This comparison of the detected ambient sound to predetermined sound characteristics can be done in the time domain or in the frequency domain. In the time domain the wave-like evaluation of the sound signal of an alarm horn may be used in order to detect an alarm horn. In the frequency domain the specific frequency components corresponding to the frequency components of an alarm horn may be used for detecting an alarm horn. In step 25 it is determined whether the detected sound comprises signal components which correspond to one of the predetermined sound characteristics. If this is not the case, the electronic system continues reproducing the audio sound as usual. If however a predetermined sound characteristic is detected in the signal, the system can react in different ways (step 26).

According to one embodiment, the sound volume of the reproduced sound may be lowered, the user of the electronic device may be informed by an audio warning, and/or a warning may be displayed to the user. The user may then have to confirm in the next step (not shown) that he or she has recognized the alarm horn. If this is the case, the sound volume can be increased to the value before the alarm horn was detected. Additionally, it is possible to lower the volume as long as the signal of the alarm horn can be detected. In step 27 the method for controlling the electronic device ends.

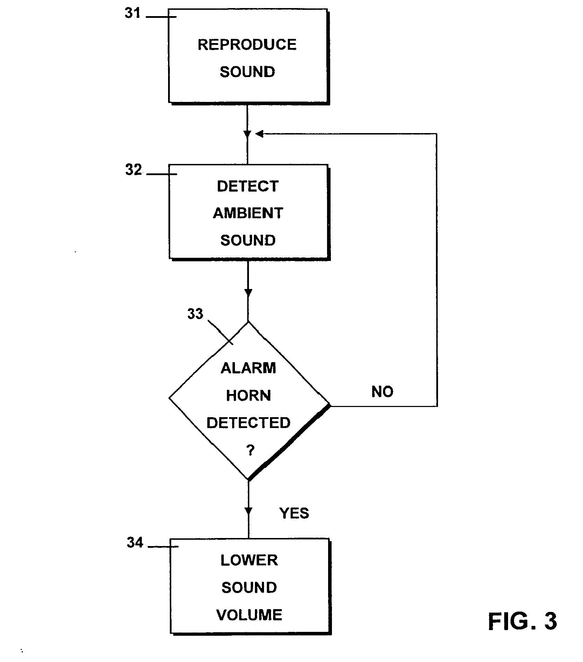

In Fig. 3 another embodiment is shown, in which, when the sound is reproduced at step 31, the ambient sound is detected at step 32. At step 33 it is asked whether an alarm horn can be detected in the detected ambient sound. If this is the case, the volume of the sound signal can be lowered at step 34. If no alarm horn is detected, the system continues to detect the ambient sound.

Summarizing, the invention provides a possibility for a user of an audio player to detect as soon as possible that a vehicle with an alarm horn is in the neighborhood. This helps to avoid dangerous situations which would occur if the user did not notice the alarm horn. The invention can be used in electronic devices incorporated into vehicles or can be used in portable audio players or mobile phones of pedestrians.

## Claims

1. Electronic device comprising
- a sound producing unit for producing sound,
- a sound reproduction unit for reproducing the produced sound,
- a sound detecting unit for detecting a predetermined sound characteristic,
- a control unit for controlling the electronic device in accordance with the detected sound characteristic.

2. Device according to claim 1, **characterized in that** the control unit controls the sound reproduced by the sound reproducing unit in accordance with the detected sound characteristic.

3. Device according to claim 2, **characterized in that** the sound control unit controls the sound intensity of the reproduced sound.

4. Device according to claim 3, **characterized in that** the sound control unit lowers the intensity of the reproduced sound when a predetermined sound characteristic is detected.

5. Device according to any of the preceding claims, **characterized in that** the predetermined sound characteristic is the signal characteristic of an alarm horn or siren of an emergency vehicle.

6. Device according to any of the preceding claims **characterized by** further comprising a storage unit for storing different sound characteristics, the detected sound characteristic being compared to the stored sound characteristics by the control unit, the control unit controlling the sound in accordance with the result of the comparison.

7. Device according to any of the preceding claims, wherein the sound control unit outputs an audio warning when a predetermined sound characteristic is detected.

8. Device according to any of the preceding claims, wherein the control unit outputs a visual warning when a predetermined sound characteristic is detected.

9. Device according to any of the preceding claims, **characterized in that** the electronic device is a built in device of a vehicle, a portable audio player or a mobile communication unit.

10. Device according to any of the preceding claims, **characterized in that** the sound reproduction unit comprises ear phones for the user of the device.

11. Device according to any of the preceding claims, **characterized in that** the sound detecting unit is a microphone of a vehicle multimedia system.

12. Method for controlling the sound of an electronic device, comprising the following steps:
- reproducing a sound produced by a sound producing unit,
- detecting the ambient sound in the neighbourhood of the reproduced sound,
- comparing the detected ambient sound to at least one predetermined sound characteristic, and
- controlling the sound of the reproduced sound depending on the comparison.

13. Method according to claim 12, wherein the sound is controlled by controlling the sound level of the reproduced sound, the sound level being lowered when the detected sound comprises a predetermined sound characteristic.

14. Method according to claim 12 or 13, wherein the sound level is lowered when the detected sound characteristic corresponds to the sound characteristic of an alarm horn or the siren of an emergency vehicle.

15. Method according to any of claims 12 to 14, wherein a visual warning is output, when the predetermined sound characteristic of an alarm horn or a siren is detected.

16. Method according to any of claim 12 to 15, **characterized by** further comprising the step of:
- detecting the sound inside a passenger compartment of a vehicle
- determining whether the detected sound comprises a predetermined sound characteristic,
- determining whether the volume of an audio sound reproduced in the vehicle is lower than a predetermined threshold value, when the predetermined sound characteristic has been detected, and
- reducing the volume of reproduced audio sound inside the vehicle if the volume exceeds the threshold value.

17. Method according to any of claims 12 to 16, wherein an audio warning is output when the predetermined sound characteristic of an alarm horn or a siren is detected.

18. Method according to any of claims 12 to 17, further comprising the steps of:
- transforming the detected ambient sound in the frequency domain
- comparing the resulting frequency spectrum to at least one predetermined frequency spectrum, and
- controlling the sound level of the reproduced sound when part of the resulting frequency spectrum corresponds to said at least one predetermined frequency spectrum.
